# EUROPÄISCHE PATENTSCHRIFT

(11) **EP 2 290 590 B1**
(45) Veröffentlichungstag und Bekanntmachung des Hinweises auf die Patenterteilung: **11.03.2015**
(21) Anmeldenummer: 10008397.1
(22) Anmeldetag: 12.08.2010
(51) Int. Cl.: G06K 19/077, H01L 23/13, H01L 23/498, H01L 23/52, H05K 1/18, H05K 3/30, H05K 3/32, H05K 3/40

(54) **Portabler Datenträger**
Portable data carrier
Support de données portatif

(30) Priorität: 14.08.2009 DE 102009037627
(43) Veröffentlichungstag der Anmeldung: 02.03.2011
(60) Teilanmeldung: 13000069.8
(73) Patentinhaber: Giesecke & Devrient GmbH, 81677 München (DE)
(72) Erfinder: Olbrich, Magnus, 81543 München (DE)

(56) Entgegenhaltungen:
- WO-A1-00/36557
- WO-A2-2009/026998
- DE-A1-102004 010 715
- DE-A1-102004 053 292
- US-A- 5 971 253
- US-A1- 2002 192 856

## Beschreibung

Die vorliegende Erfindung betrifft einen portablen Datenträger mit einem in einen Datenträgerkörper des Datenträgers eingebetteten elektronischen Modul, ein entsprechendes Modul, einen Datenträgerkörper, ein elektrisch leitfähiges Material zum Verbinden des Moduls mit einer elektrischen Komponente des Datenträgerkörpers sowie ein Verfahren zum Herstellen eines solchen Datenträgers.

Portable, meist kartenförmige Datenträger, insbesondere Chipkarten, werden in vielen Bereichen eingesetzt, beispielsweise als Ausweisdokumente, zum Nachweis einer Zugangsberechtigung zu einem Mobilfunknetz oder zur Durchführung von Transaktionen des bargeldlosen Zahlungsverkehrs. Eine Chipkarte weist einen Kartenkörper und einen in den Kartenkörper eingebetteten integrierten Schaltkreis auf. Um eine effiziente Herstellung der Chipkarte zu ermöglichen, wird der integrierte Schaltkreis bei einer Vielzahl von Herstellungsverfahren zunächst in ein Chipmodul verpackt und anschließend wird das Chipmodul in den Kartenkörper eingebaut. In der Regel wird das Chipmodul in eine Aussparung des Kartenkörpers eingeklebt.

Eine Kommunikation mit dem integrierten Schaltkreis kann über ein Kontaktfeld der Chipkarte abgewickelt werden, das hierzu von einer Kontaktiereinheit berührend kontaktiert wird. Das Kontaktfeld ist in der Regel Bestandteil des Chipmoduls. Alternativ oder zusätzlich zur Kommunikation über das Kontaktfeld kann eine kontaktlose Kommunikation vorgesehen sein. Hierzu kann der Kartenkörper eine Antennenspule aufweisen, die beim Einbau des Chipmoduls mit dem integrierten Schaltkreis elektrisch leitend verbunden wird. Abhängig vom Einsatzgebiet der Chipkarte kann der Kartenkörper außer der Antennenspule auch andere oder weitere elektrische Komponenten aufweisen, die beim Einbau des Chipmoduls mit dem integrierten Schaltkreis elektrisch leitend verbunden werden.

Bei der überwiegenden Zahl der für den Einbau eines Chipmoduls in einen Kartenkörper verwendeten Techniken sind die Bereiche, in denen die elektrisch leitenden Verbindungen zwischen dem integrierten Schaltkreis des Chipmoduls und der elektrischen Komponente des Kartenkörpers ausgebildet werden, nicht direkt mittels eines Werkzeugs zugänglich. Es sind daher Kontaktierungsverfahren erforderlich, die trotz dieser fehlenden Zugangsmöglichkeit eine Ausbildung einer elektrisch leitenden Verbindung zwischen dem integrierten Schaltkreis und der elektrischen Komponente ermöglichen.

Gemäß der DE 10 2004 053 292 A1 wird ein elektrisch leitender Kontakt zwischen einer Kontakteinrichtung einer elektrischen Komponente des Datenträgerkörpers, beispielsweise einer Antennenspule, und einer Kontakteinrichtung eines elektronischen Moduls, beispielsweise eines Chipmoduls, dadurch hergestellt, dass die jeweiligen Kontakteinrichtungen mittels ineinander greifender Anordnungen kraftschlüssig miteinander verbunden werden. Der DE 2005 002 731 A1 folgend wird das Modul derart in den Datenträgerkörper eingepresst, dass die entsprechenden Kontakteinrichtungen, die jeweils als glatte Flächen ausgebildet sind, gegeneinander gepresst werden. In der DE 10 2004 053 291 A1 werden die jeweiligen Kontakteinrichtungen durch eine Legierung stoffschlüssig miteinander verbunden, welche jeweils ein auf die beiden Kontakteinrichtungen aufgebrachtes Material umfasst. Gemäß der DE 10 2005 002 733 A1 ist die Kontakteinrichtung des Moduls als ein elektrisch leitfähiges Band ausgebildet, welches mittels spitz zulaufender Erhebungen, welche eine elektrisch isolierende Schicht durchdringen, die Kontakteinrichtung der elektrischen Komponente des Datenträgerkörpers kontaktieren.

Die DE 10 2005 002 726 A1, DE 10 2005 002 732 A1 sowie die DE 10 2005 002 728 A1 lehren, die Kontakteinrichtung der elektrischen Komponente des Datenträgers mit der Kontakteinrichtung des elektronischen Moduls, welche jeweils verschiedenartig ausgebildet sind, mittels eines leitfähigen Materials elektrisch leitend zu verbinden, vorzugsweise mittels eines Lots oder eines aushärtenden Leitklebers, wodurch die beiden Kontakteinrichtungen stoffschlüssig miteinander verbunden werden.

Die verschiedenen Arten der Verbindung zwischen den beiden Kontakteinrichtungen, wie sie vorstehend skizziert worden sind, haben den Nachteil, dass eine derart kraftschlüssig oder stoffschlüssig hergestellte Verbindung aufgrund der starken mechanischen Beanspruchungen an den Datenträger leicht unterbrochen werden kann, wenn sich das Modul relativ zu dem Datenträgerkörper, wenn auch nur geringfügig, verschiebt. Unmittelbar kontaktierte Kontakteinrichtungen können dabei den Kontakt verlieren, stoffschlüssige Verbindungen aufbrechen.

Gemäß der DE 102 57111 A1 wird ein elastisches, elektrisch leitfähiges Material zum Verbinden des Moduls mit der Komponente des Datenträgers verwendet, wobei das Material beim Einbetten des Moduls in den Datenträgerkörper durch die Kontakteinrichtung des elektrischen Moduls des Datenträgerkörpers und der Kontakteinrichtung des Moduls zusammengedrückt wird. Bei nachlassender Druckbeaufschlagung des Materials, beispielsweise aufgrund einer vertikalen Verschiebung des Moduls in dem Datenträgerkörper aufgrund einer Biegebelastung auf den Datenträger, kann die Verbindung zumindest solange aufrechterhalten werden, wie die Elastizität des Materials diese Verschiebung ausgleichen kann, was allerdings nur in begrenztem Maße möglich ist.

Die US 2002/0192856 A1, die als nächstliegendster Stand der Technik gesehen wird, beschreibt ein Verfahren zum Verbinden eines Chips mit einer Antenne einer kontaktlos kommunizierenden Chipkarte. Die Antenne weist verformbare Kontakte auf und ist unter Verwendung einer leitfähigen Tinte auf einen Antennenträger aufgedruckt, welcher aus verformbarem Material besteht. Das Verfahren umfasst die Schritte des Positionierens des Chips, welcher nicht verformbare Kontakte umfasst, auf dem Antennenträger, so dass die Kontakte des Chips in Richtung der Kontakte der Antenne zeigen, und des Ausübens einer Druckkraft auf den Chip derart, dass die Kontakte des Chips den Antennenträger und die Kontakte der Antenne als Ergebnis der Drucks verformen, wobei der Träger und die Antennenkontakte verformt bleiben, nachdem der Druck nachgelassen hat. Dadurch kann eine beträchtliche Kontaktoberfläche zwischen den Kontakten des Chips und den Antennenkontakten erhalten werden.

Die WO 2009/026998 A2 beschreibt das Erzeugen einer Verbindung eines Anschlussflächen umfassenden RF-Chips mit einem portablen Datenträger, indem die Anschlussflächen des Chips in eine Öffnung eines den Datenträger bildenden Substrats, welches Leiterbahnen umfasst, eingeführt und mit dem Substrat verbunden wird, indem die Anschlussflächen des Chips mit den Leiterbahnen des Substrats verbunden werden. Nachdem diese Verbindung hergestellt ist, wird die Öffnung des Substrats mit dem darin angeordneten Chip mit einer dichtenden Masse ausgegossen.

Die DE 10 2004 010 715 A1 zeigt eine Chipkarte zur kontaktlosen Datenübertragung, welche aus einem Chipmodul und einem Kartenkörper zusammengesetzt ist. Das Chipmodul umfasst einen Träger mit einer ersten und einer zweiten Seite, wobei auf der ersten Seite ein Halbleiterchip und ein Kontaktvermittler sowie eine elektrisch leitfähige Verbindung zwischen dem Halbleiterchip und dem Kontaktvermittler angeordnet sind. Der Kartenkörper umfasst eine Antenne for eine induktive Datenübertragung sowie eine freigelegte Anschlussstelle der Antenne Zwischen der ersten Seite des Trägers des Chipmoduls und der freigelegten Antenne des Kartenkörpers befindet sich eine elektrisch leitfähiges Mittel zum Verbinden der Antenne mit dem Halbleiterchip. In dieses elektrisch leitfähige Mittel ragt der Kontaktvermittler hinein.

Aufgabe der vorliegenden Erfindung ist es, eine weiter verbesserte, auf den Datenträgerkörper einwirkenden mechanischen Belastungen standhaltende elektrisch leitende Verbindung zwischen einer elektrischen Komponente eines Datenträgerkörpers und einem in den Datenträgerkörper eingebetteten Modul auf einfache Weise herzustellen.

Diese Aufgabe wird durch einen portablen Datenträger, ein elektronisches Modul, sowie ein Verfahren zur Herstellung des Datenträgers mit den Merkmalen der unabhängigen Ansprüche gelöst. Vorteilhafte Ausgestaltungen und Weiterbildungen sind in den abhängigen Ansprüchen angegeben.

Ein erfindungsgemäßer Datenträger umfasst dabei einen Datenträgerkörper mit einer elektrischen Komponente sowie ein elektronisches Modul, welches zumindest teilweise in den Datenträgerkörper eingebettet ist und über eine Modulkontakteinrichtung des Moduls mittels eines elastischen, elektrisch leitfähigen Materials unter Druckbeaufschlagung elektrisch leitend mit einer Komponentenkontakteinrichtung der elektrischen Komponente des Datenträgers verbunden ist. Erfindungsgemäß ist die Modulkontakteinrichtung räumlich strukturiert ausgebildet und in das elastische, elektrisch leitfähige Material ist durch die räumlich strukturierte Modulkontakteinrichtung eine räumliche Struktur eingeprägt.

Ein erfindungsgemäßes elektronisches Modul ist geeignet, zumindest teilweise in einen Datenträgerkörper eines portablen Datenträgers eingebettet zu werden und umfasst eine Modulkontakteinrichtung zum elektrisch leitenden Verbinden des Moduls mit einem elastischen, elektrisch leitfähigen Material des Datenträgers. Erfindungsgemäß ist die Modulkontakteinrichtung derart räumlich strukturiert ausgebildet, dass sie geeignet ist, beim Einbetten des Moduls in den Datenträgerkörper unter Druckbeaufschlagung eine räumliche Struktur in das elastische, elektrisch leitfähige Material einzuprägen.

Ein elastisches, elektrisch leitfähiges Material ist geeignet zum elektrisch leitenden Verbinden eines elektronischen Moduls und einer elektrischen Komponente eines portablen Datenträgers beim zumindest teilweisen Einbetten des Moduls in einen Datenträgerkörper des Datenträgers. Das Material ist erfindungsgemäß derart ausgebildet, dass beim Einbetten des Moduls in den Datenträgerkörper durch die räumliche Strukturierung der Modulkontakteinrichtung unter Druckbeaufschlagung eine räumliche Struktur in das Material eingeprägt wird.

Ein Datenträgerkörper mit einer elektrischen Komponente ist demnach geeignet zum Herstellen eines erfindungsgemäßen Datenträgers durch zumindest teilweises Einbetten eines erfindungsgemäßen Moduls und elektrisches Verbinden der Modulkontakteinrichtung des Moduls mit einer Komponentenkontakteinrichtung der elektrischen Komponente mittels eines erfindungsgemäßen elastischen, elektrisch leitfähigen Materials unter Druckbeaufschlagung des Materials durch die Modulkontakteinrichtung.

Gemäß einem erfindungsgemäßen Verfahren zur Herstellung eines portablen Datenträgers mit einem Datenträgerkörper sowie einem elektronischen Modul werden in einem ersten Schritt ein entsprechender Datenträgerkörper mit einer elektrischen Komponente, ein elektronisches Moduls sowie ein elastisches, elektrisch leitfähiges Material bereitgestellt. Danach wird das Material in einer Aussparung des Datenträgerkörpers derart angeordnet, dass das Material mit einer Komponentenkontakteinrichtung der elektrischen Komponente des Datenträgerkörpers elektrisch leitend verbunden wird. In einem weiteren Schritt wird das Modul in den Datenträgerkörper zumindest teilweise derart eingebettet, dass das Material die Komponentenkontakteinrichtung und eine Modulkontakteinrichtung des Moduls unter Druckbeaufschlagung elektrisch leitend verbindet. Erfindungsgemäß wird die Modulkontakteinrichtung räumlich strukturiert ausgebildet und das Material wird beim Einbetten des Moduls durch die Modulkontakteinrichtung räumlich strukturiert geprägt.

Dadurch, dass die Modulkontakteinrichtung räumlich strukturiert ausgebildet ist und beim Einbetten des Moduls in den Datenträgerkörper eine entsprechende räumliche Struktur in das derart eingerichtete elektrisch leitfähige Material eingeprägt wird, kann die zwischen dem Modul und der elektrischen Komponente des Datenträgerkörpers hergestellte elektrisch leitende Verbindung noch ausfallsicherer bereitgestellt werden. Durch das Einprägen der Struktur in das Material einerseits und die strukturierte Kontaktfläche der Modulkontakteinrichtung andererseits bleibt ein elektrisch leitender Kontakt zwischen der Modulkontakteinrichtung und dem Material auch bei Verschiebung des Moduls gegen den Datenträgerkörper aufgrund einer mechanischen Beanspruchung an den Datenträgerkörper, beispielsweise eine Biegung desselben, länger erhalten, als wenn die Kontaktfläche der Modulkontakteinrichtung flach ausgebildet wäre. Sowohl horizontale, insbesondere aber vertikale Verschiebungen des Moduls gegenüber dem Datenträgerkörper führen deswegen erst spät, d.h. bei sehr starker Verschiebung des Moduls, zu einer Unterbrechung der elektrisch leitenden Verbindung von Modul und elektrischer Komponente. Dies liegt daran, dass sich das elastische Material und die darin eingedrückte räumlich strukturierte Kontaktfläche der Modulkontakteinrichtung aufgrund der Elastizität des Materials und der Strukturierung der Kontaktfläche in einem Eingriff befinden, der sich auch bei nachlassender Druckbeaufschlagung des Materials durch die Modulkontakteinrichtung nur allmählich löst. Auf diese Weise ist die elektrisch leitende Verbindung auch bei starker mechanischer Beanspruchung an den Datenträger maximal lange stabil.

Die Herstellung des Datenträgers kann in bekannter, einfacher Weise durch Einbetten des Moduls in den Datenträgerkörper geschehen. Durch die dabei entstehende Druckbeaufschlagung des Materials durch die räumlich strukturierte Modulkontakteinrichtung wird das Material automatisch entsprechend geprägt. Bekannte Herstellungsverfahren müssen also lediglich hinsichtlich der Herstellung der räumlich strukturierten Kontaktfläche der Modulkontakteinrichtung und hinsichtlich der Bereitstellung eines geeigneten elastischen, elektrisch leitfähigen Materials, welches durch die strukturierte Modulkontakteinrichtung prägbar ist, angepasst werden. Sämtliche weiteren Produktionsschritte können unverändert bleiben.

Erfindungsgemäß ist das elastische, elektrisch leitfähige Material derart ausgebildet, dass die durch die räumlich strukturierte Modulkontakteinrichtung geprägte räumliche Struktur in dem Material auch bei nachlassender Druckbeaufschlagung des Materials im Wesentlichen erhalten bleibt. Dadurch kann der Kontakt zwischen der elektrischen Komponente und dem Modul über das elektrisch leitfähige Material auch bei einer starken vertikalen Verschiebung des Moduls gegenüber dem Datenträgerkörper erhalten werden, solange sich die Modulkontakteinrichtung vertikal entlang einer Flanke der Prägung des Materials verschiebt, auch wenn die Elastizität des Materials keine weitere vertikale Ausdehnung des Materials mehr erlaubt. Im Vergleich zur Verwendung einer herkömmlichen flachen, räumlich nicht strukturierten Modulkontakteinrichtung kann hier eine stärkere vertikale Verschiebung des Moduls ohne Kontaktunterbrechung gewährleistet werden. Die Verschiebung kann in vertikaler Richtung um eine Tiefe der eingeprägten, bei nachlassender Druckbeaufschlagung aufrechterhaltenen räumlichen Struktur des Materials größer ausfallen als bei Verwendung einer flachen Kontaktfläche, ohne dass der Kontakt abbricht.

Die Modulkontakteinrichtung ist flächig ausgebildet und eine beim Einbetten des Moduls in den Datenträgerkörper dem elastischen, elektrisch leitfähigen Material bzw. bei eingebettetem Modul im Datenträgerkörper der Komponentenkontakteinrichtung zugewandte Kontaktfläche der Modulkontakteinrichtung ist durch Aussparungen, insbesondere Rillen, Löcher oder dergleichen, räumlich strukturiert. Die Aussparungen können die gleichen oder aber verschiedene Tiefen aufweisen und als Muster, beispielsweise als Waffelmuster, oder aber zufällig angeordnet sein. Die Flanken der Aussparungen können jeden geeigneten Winkel zur Modulkontakteinrichtung einnehmen.

Erfindungsgemäß verjüngen sich zumindest einige der Aussparungen beim Einbetten des Moduls in Richtung des elastischen, elektrisch leitfähigen Materials bzw. bei eingebettetem Modul im Datenträger in Richtung der Komponentenkontakteinrichtung der elektrischen Komponente. Beim Einbetten des Moduls in diese sich verjüngenden Aussparungen eingedrungenes Material löst sich bei nachlassender Druckbeaufschlagung auf das Material bei vertikaler Verschiebung des Moduls aufgrund der sich verjüngenden Ausgestaltung der Aussparungen nur allmählich von der Kontaktfläche der Modulkontakteinrichtung, so dass der Kontakt zwischen dem Modul und der elektrischen Komponente auch bei starker vertikaler Verschiebung des Moduls im Datenträger aufrechterhalten werden kann.

Vorzugsweise sind die Aussparungen über die gesamte Kontaktfläche verteilt angeordnet. Die Erhebungen zwischen den Aussparungen sind zumindest teilweise miteinander elektrisch leitend verbunden. Dies gilt sowohl für die Erhebungen, welche mit dem elastischen, elektrisch leitfähigen Material verbunden sind, als auch für die Erhebungen, welche nicht mit dem elastischen, elektrisch leitfähigen Material verbunden sind. Dabei können sich die Aussparungen, die in den Randbereichen der Kontaktfläche angeordnet sind, von denen unterscheiden, die in einem zentralen Bereich der Kontaktfläche vorliegen, welche beispielsweise tiefer sein können. Es ist auch möglich, dass die Aussparungen über die gesamte Kontaktfläche gleichartig ausgebildet sind oder aber lediglich in vorgegebenen Teilbereichen der Kontaktfläche vorliegen.

Die Erfindung wird im Folgenden mit Bezug auf die beiliegenden Zeichnungen beispielhaft beschrieben. Darin zeigen:
- Figur 1: eine Draufsicht auf eine bevorzugte Ausführungsform eines erfindungsgemäßen Datenträgers;
- Figur 2: einen Ausschnitt eines Datenträgerkörpers des Datenträgers aus Fig. 1 in Draufsicht ohne eingebettetes elektronisches Modul;
- Figur 3: einen Ausschnitt einer bevorzugten Ausführungsform eines erfindungsgemäßen elektronischen Moduls in Schnittansicht;
- Figur 4: den Ausschnitt aus Fig. 3 in Untersicht;
- Figur 5: den Ausschnitt des Datenträgerkörpers aus Fig. 2 in Schnittansicht zusammen mit erfindungsgemäßem elastischem, elektrisch leitfähigem Material;
- Figur 6: den Ausschnitt aus Fig. 5 mit eingebettetem Modul aus Fig. 3; und
- Figur 7: einen vergrößerten Ausschnitt aus der Anordnung aus Fig. 6, wobei sich das Modul vertikal gegenüber dem Datenträgerkörper verschoben hat.

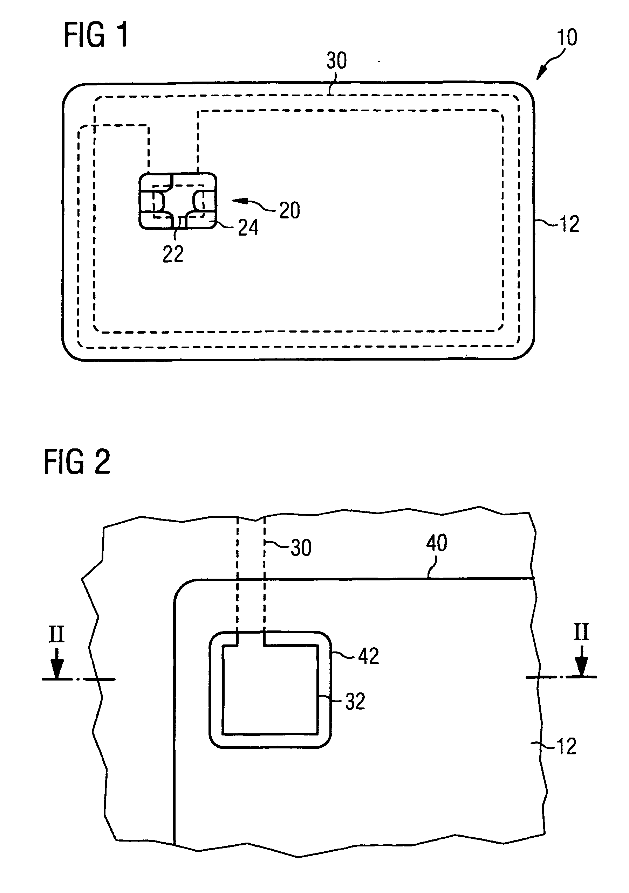

Figur 1 zeigt einen portablen Datenträger 10 in Form einer Chipkarte in einer schematischen Draufsicht. Der Datenträger 10 besitzt einen Datenträgerkörper 12, in den ein elektronisches Modul 20 in Form eines Chipmoduls eingebettet ist. Das Modul 20 umfasst einen integrierten Schaltkreis zum Speichern und/oder Verarbeiten von Daten, welcher in einen Vergusskörper 22 vergossen ist. Weiterhin verfügt das Modul 20 über ein Kontaktfeld 24, das an der Außenseite des Datenträgerkörpers 12 angeordnet ist und den im Inneren des Datenträgerkörpers 12 angeordneten integrierten Schaltkreis überdeckt. Zwischen dem integrierten Schaltkreis und dem Kontaktfeld 24 sind mehrere (nicht gezeigte) elektrisch leitende Verbindungen ausgebildet, so dass dem integrierten Schaltkreis über das Kontaktfeld 24 elektrische Signale zugeführt werden können und der elektrische Schaltkreis über das Kontaktfeld 24 Signale aussenden kann. Hierzu kann das Kontaktfeld 24 mit einem (nicht gezeigten) Lesegerät verbunden werden.

Der Datenträgerkörper 12 weist in seinem Inneren eine elektrische Komponente 30 in Form einer Antennenspule auf. Diese kann beispielsweise als gedruckte oder geätzte Spule oder als Drahtspule ausgebildet sein. Die Antenne 30 ist elektrisch leitend mit dem integrierten Schaltkreis verbunden und ermöglicht analog zum Kontaktfeld eine Übertragung von Signalen, die von dem Schaltkreis empfangen und/oder gesendet werden. Im Falle der Antennenspule 30 erfolgt eine entsprechende Datenübertragung kontaktlos. Dazu wird der Datenträger 10 in einem geeigneten Abstand zu einem (nicht gezeigten) Lesegerät angeordnet.

Alternativ oder zusätzlich zu der Antennenspule 30 können in dem Datenträgerkörper 12 des Datenträgers 10 aus Fig. 1 weitere (nicht dargestellte) elektrische Komponenten 30 angeordnet sein, beispielsweise eine Anzeige, ein Schalter, ein Sensor, eine Batterie und dergleichen. Auch diese elektrischen Komponenten können, wie nachfolgend detailliert beschrieben, mit dem integrierten Schaltkreis elektrisch leitend verbunden werden.

Fig. 2 zeigt den Datenträgerkörper 12 aus Fig. 1 vor dem Einsetzen des Moduls 20 ausschnittsweise in einer schematisierten Draufsicht. Der Datenträgerkörper 12 umfasst eine Aussparung 40, in die das Modul 20 zumindest teilweise eingebettet wird. Die Aussparung 40 ist mehrstufig ausgebildet und umfasst eine weitere Aussparung 42. Die Aussparung 42 ist im Vergleich zur Aussparung 40 tiefer ausgebildet. Am Boden der Aussparung 42 tritt eine Komponentenkontakteinrichtung 32 der elektrischen Komponente 30, welche ansonsten in dem Datenträgerkörper 12 unzugänglich eingebettet ist, hervor und ist dort direkt kontaktierbar. Die Komponentenkontakteinrichtung 32 ist einteilig mit der Komponente 30 ausgebildet. Es ist auch möglich, die Komponentenkontakteinrichtung 32 separat auszubilden und elektrisch leitend mit der Komponente 30 zu verbinden.

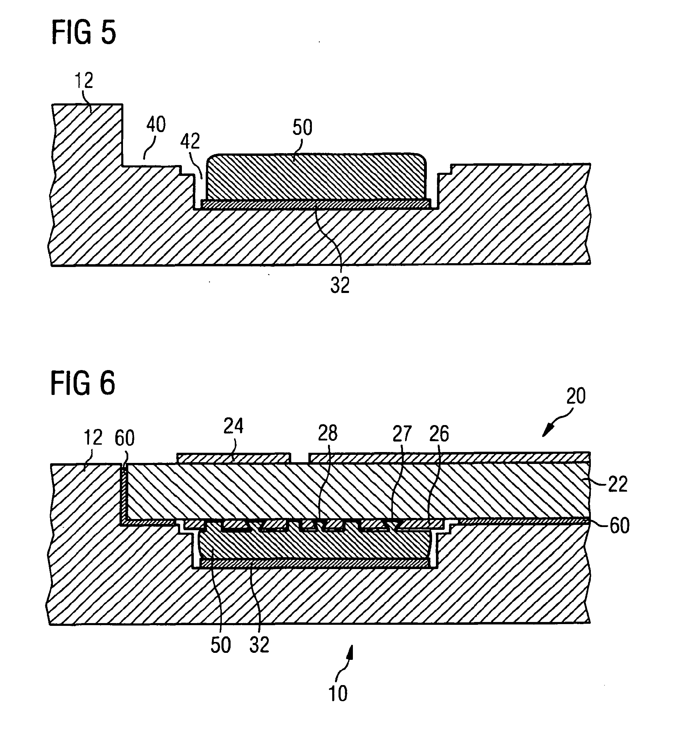

Fig. 5 zeigt den gleichen Ausschnitt des Datenträgerkörpers 12 in einer Schnittansicht entlang der Linie II-II aus Fig. 2, wobei in die Aussparung 42 zusätzlich eine Menge eines elastischen, elektrisch leitfähigen Materials 50 eingebracht worden ist, welches, wie nachfolgend detailliert beschrieben, zum elektrisch leitenden Verbinden des Moduls 20 mit der Komponente 30 dient. Der Datenträgerkörper 12 kann mittels verschiedener Verfahren gebildet werden, beispielsweise im Spritzgussverfahren oder durch Laminieren verschiedener Folien. Die Aussparungen 40, 42 können dabei in den Folien bereits vorgesehen sein, beispielsweise ausgestanzt, oder aber aus dem Datenträgerkörper herausgefräst werden.

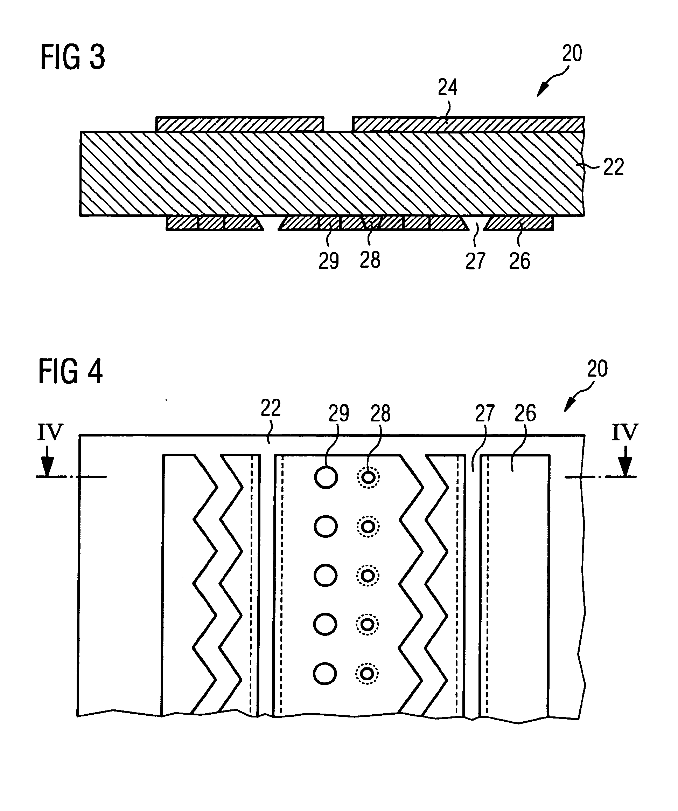

In Fig. 3 ist das elektronische Modul 20 ausschnittsweise in einer seitlichen Schnittansicht schematisch gezeigt. In dem Vergusskörper 22 ist der integrierten Schaltkreis geschützt vergossen. Das Kontaktfeld 24 und eine auf der Unterseite des Vergusskörpers 22 angeordnete Kontaktfläche einer Modulkontakteinrichtung 26 sind mit dem integrierten Schaltkreis elektrisch leitend, beispielsweise über (nicht gezeigte) Bond-Drähte, verbunden. Die Modulkontakteinrichtung 26 in Form der gezeigten Kontaktfläche ist räumlich strukturiert ausgebildet und umfasst dazu Aussparungen 27, 28, 29 in Form von Rillen 27 und Löchern 28, 29. Alternativ oder zusätzlich zu den Aussparungen 27, 28, 29 können auch Vorsprünge (nicht gezeigt) vorgesehen sein.

Die Ansicht der Fig. 3 entspricht dabei einem Schnitt entlang der Linie IV-IV aus Fig. 4, welche das entsprechende Modul 20 in Untersicht zeigt. Wie in Fig. 4 angedeutet, können die Aussparungen 27, 28, 29 verschiedenste Formen annehmen und über die gesamte Kontaktfläche angeordnet sein. Es ist weiterhin möglich, Aussparungen 27, 28, 29 verschiedener Tiefen vorzusehen. Die Aussparungen 27, 28, 29 können die Kontaktfläche in Form eines Musters räumlich strukturieren oder aber eher zufällig oder lediglich in vorgesehen Bereichen der Kontaktfläche angeordnet sein. Die Modulkontakteinrichtung 26 kann anstelle einer strukturierten Kontaktfläche auch aus einzelnen, von einander getrennten, von der Vergussfläche 22 hervorstehenden, eventuell selbst wieder räumlich strukturierten Kontaktelementen (nicht gezeigt) gebildet sein. Gemäß einer weiteren Ausführungsform (nicht gezeigt) kann entlang des Randes der Kontaktfläche zusätzlich ein umlaufender Wall ausgebildet sein, der sich beim Einbetten in Richtung der Komponentenkontakteinrichtung 32 erstreckt und dazu dient, das Einfließen von Kleber 60 (vgl. Fig. 6) oder dergleichen in die Aussparung 42 (vgl. Fig. 5) beim Einbetten und Verkleben des Moduls 20 in der Aussparung 40 (vgl. Fig. 5) des Datenträgerkörpers 12 zu verhindern.

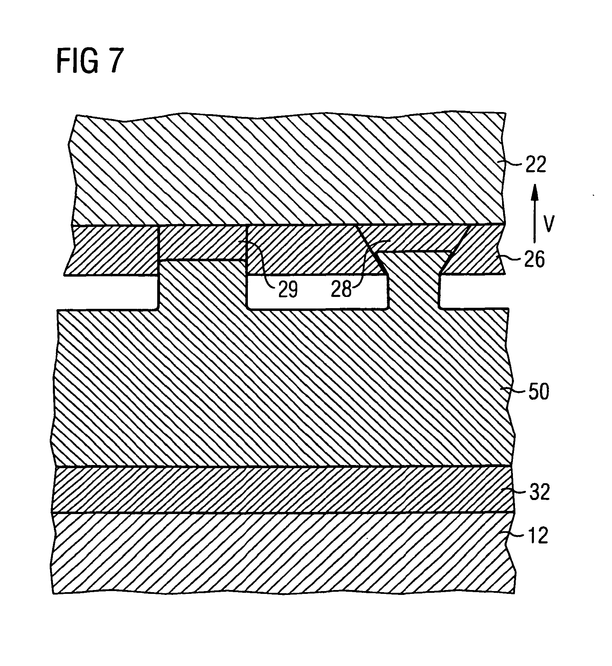

Wie in Fig. 3 gezeigt und in Fig. 4 durch die gestrichelten Linien angedeutet, sind einzelne der Aussparungen 27, 28 derart ausgebildet, dass sie sich in Richtung von dem Vergusskörper weg, d.h. beim Einbetten des Moduls (vgl. Fig. 6, 7) in Richtung des elastischen Materials 50 bzw. der Komponentenkontakteinrichtung 32 hin verjüngen. Eine solche verjüngende Ausgestaltung kann für alle Aussparungen 27, 28, 29 vorgesehen sein oder aber lediglich für einige. Es sind auch Ausführungsformen der Modulkontakteinrichtung 26 möglich, die keine derart sich verjüngenden Aussparungen umfassen.

In Fig. 6 ist gezeigt, wie das Modul 20 aus Fig. 3 in die Aussparung 40 des Datenträgerkörpers 12 eingebettet und mittels eines geeigneten Klebers 60, beispielsweise eines Heißklebers, darin verklebt worden ist. Dabei ist das elastische, elektrisch leitfähige Material 50 durch die räumlich strukturierte Modulkontakteinrichtung 26 in Form der mit den Aussparungen 27, 28, 29 versehenen Kontaktfläche unter Druckbeaufschlagung geprägt worden und zeigt eine entsprechende räumliche Struktur auf der dem Modul 20 zugewandeten Seite. Der in dem Vergusskörper 22 vergossene integrierte Schaltkreis, welcher, wie erwähnt, mit der Modulkontakteinrichtung 26 elektrisch leitend verbunden ist, wird dadurch, über das elektrisch leitfähige Material 50 und die Komponentenkontakteinrichtung 32 mit der elektrischen Komponente 30, im gezeigten Beispiel der Antenne, elektrisch leitend verbunden.

Aufgrund der Elastizität des Materials 50, der Menge des in die Aussparung 42 eingebrachten Materials 50 sowie des Drucks durch die Kontaktfläche der Modulkontakteinrichtung 26 werden Anteile des Materials 50 in die Aussparungen 27, 28, 29 der Kontaktfläche des Moduls 20 eingepresst. Das Material 50 ist so gewählt, dass die eingeprägte Struktur auch bei nachlassender Druckbeaufschlagung durch die Modulkontakteinrichtung 26 im Wesentlichen erhalten bleibt. Dies ist in Fig. 7 exemplarisch gezeigt.

Der bezüglich Fig. 6 vergrößerte Ausschnitt in Fig. 7 veranschaulicht ein vertikales Verschieben des Moduls 20 (in Richtung des Pfeils V) relativ zu dem Datenträgerkörper 12 mit der Komponentenkontakteinrichtung 32 und dem elastischen, elektrisch leitfähigen Material 50. Lässt der Druck auf das Material 50 nach, wenn die Kontaktfläche der Modulkontakteinrichtung 26 zurückweicht, so entspannt sich das Material 50 in begrenztem Rahmen zu seiner Ausgangsdicke (vgl. Fig. 5). Schon aus diesem Grund kann der Kontakt zwischen der Modulkontakteinrichtung 26 und dem Material 50 bei geringfügiger Verschiebung des Moduls 20 erhalten bleiben. Ist diese Verschiebung allerdings zu stark, um alleine durch Elastizität des Materials 50 aufgefangen zu werden, so bleibt der Kontakt doch noch entlang der Flanken der räumlich geprägten Struktur in dem Material 50, welche sich entlang der Flanken der Aussparungen 28, 29 der Kontaktfläche der Modulkontakteinrichtung 26 bewegen, bestehen (vgl. Fig. 7). Dieser Effekt kann noch dadurch gesteigert werden, dass die Aussparungen 28 sich in Richtung des Materials 50 bzw. in Richtung der Komponentenkontakteinrichtung 32 hin verjüngen. In solche Aussparungen beim Einbetten des Moduls 20 eingepresstes Material 50 zieht sich bei Verschiebung des Moduls in vertikaler Richtung nur unter Widerstand aus der Aussparung 28 zurück. Auf diese Weise kann der Kontakt zwischen dem Modul 20 und der Komponente 30 über die entsprechenden Kontakteinrichtungen 32, 26 und das Material 50 auch bei starker mechanischer Belastung an den Datenträgerkörper 12 mit daraus resultierender Verschiebung des Moduls 20 relativ zum Datenträgerkörper 12 maximal lange aufrecht erhalten werden.

## Patentansprüche

1. Portabler Datenträger (10), umfassend einen Datenträgerkörper (12) mit einer elektrischen Komponente (30) sowie ein elektronisches Modul (20), welches zumindest teilweise in den Datenträgerkörper (12) eingebettet ist und über eine Modulkontakteinrichtung (26) des Moduls (20) mittels eines elastischen, elektrisch leitfähigen Materials (50) unter Druckbeaufschlagung elektrisch leitend mit einer Komponentenkontakteinrichtung (32) der elektrischen Komponente (30) des Datenträgers (10) verbunden ist, wobei die Modulkontakteinrichtung (26) räumlich strukturiert ausgebildet ist und in das elastische, elektrisch leitfähige Material (50) durch die räumlich strukturierte Modulkontakteinrichtung (26) eine räumliche Struktur eingeprägt ist, wobei die Modulkontakteinrichtung (26) flächig ausgebildet ist und eine der Komponentenkontakteinrichtung (32) zugewandte Kontaktfläche der Modulkontakteinrichtung (26) durch Aussparungen (27; 28; 29) räumlich strukturiert ist, **dadurch gekennzeichnet, dass** sich zumindest einige der Aussparungen (27; 28) in Richtung der Komponentenkontakteinrichtung (32) verjüngen.

2. Datenträger (10) nach Anspruch 1, **dadurch gekennzeichnet, dass** das elastische, elektrisch leitfähige Material (50) derart ausgebildet ist, dass die durch die räumlich strukturierte Modulkontakteinrichtung (26) eingeprägte räumliche Struktur in dem Material (50) auch bei nachlassender Druckbeaufschlagung im Wesentlichen erhalten bleibt.

3. Datenträger (10) nach Anspruch 1 oder 2, **dadurch gekennzeichnet, dass** die Aussparungen (27; 28; 29) im Wesentlichen auf der gesamten Kontaktfläche der Modulkontakteinrichtung (26) verteilt sind.

4. Elektronisches Modul (20), geeignet zum zumindest teilweisen Einbetten in einen Datenträgerkörper (12) eines portablen Datenträgers (10), umfassend eine Modulkontakteinrichtung (26) zum elektrisch leitenden Verbinden des Moduls (20) mit einem elastischen, elektrisch leitfähigen Material (50) des Datenträgers (10), wobei die Modulkontakteinrichtung (26) derart räumlich strukturiert ausgebildet ist, dass sie geeignet ist, beim Einbetten des Moduls (20) in den Datenträgerkörper (12) unter Druckbeaufschlagung eine räumliche Struktur in das elastische, elektrisch leitfähige Material (50) einzuprägen, wobei
die Modulkontakteinrichtung (26) flächig ausgebildet ist und eine beim Einbetten dem elastischen Material (50) zugewandte Kontaktfläche der Modulkontakteinrichtung (26) durch Aussparungen (27; 28; 29) räumlich strukturiert ist,
**dadurch gekennzeichnet, dass** sich zumindest einige der Aussparungen (27; 28) in Richtung der beim Einbetten dem elastischen Material (50) zugewandten Seite der Kontaktfläche verjüngen.

5. Modul (20) nach Anspruch 4, **dadurch gekennzeichnet, dass** die Aussparungen (27; 28; 29) im Wesentlichen auf der gesamten Kontaktfläche der Modulkontakteinrichtung (26) verteilt sind.

6. Verfahren zur Herstellung eines portablen Datenträgers (10) mit einem Datenträgerkörper (12) sowie einem elektronischen Modul (20), umfassend die Schritte:
- Anordnen eines elastischen, elektrisch leitfähigen Materials (50) in einer Aussparung (42) des Datenträgerkörpers (12) derart, dass das Material (50) mit einer Komponentenkontakteinrichtung (32) einer elektrischen Komponente (30) des Datenträgerkörpers (12) elektrisch leitend verbunden wird;
- zumindest teilweises Einbetten des Moduls (20) in den Datenträgerkörper (12) derart, dass das Material (50) die Komponentenkontakteinrichtung (32) und eine Modulkontakteinrichtung (26) des Moduls (20) unter Druckbeaufschlagung elektrisch leitend verbindet;
- wobei die Modulkontakteinrichtung (26) räumlich strukturiert ausgebildet wird,
**dadurch gekennzeichnet, dass**
das Material (50) beim Einbetten des Moduls (20) durch die Modulkontakteinrichtung (26) räumlich strukturiert derart geprägt wird, dass die eingeprägte räumliche Struktur in dem Material (50) auch bei nachlassender Druckbeaufschlagung durch die Modulkontakteinrichtung (26) im Wesentlichen erhalten bleibt,
wobei sich zumindest einige der Aussparungen (27, 28) in Richtung der Komponentenkontakteinrichtung (32) verjüngen.

## Claims

1. A portable data carrier (10), comprising a data carrier body (12) having an electrical component (30) as well as an electronic module (20) which is at least partially embedded in the data carrier body (12) and is electroconductively connected under the application of pressure to a component contacting device (32) of the electrical component (30) of the data carrier (10) via a module contacting device (26) of the module (20) by means of an elastic, electroconductive material (50), wherein the module contacting device (26) is configured to be spatially structured and a spatial structure is embossed in the elastic, electroconductive material (50) by the spatially structured module contacting device (26), wherein the module contacting device (26) is configured to be flat and a contact area of the module contacting device (26) facing the component contacting device (32) is spatially structured by gaps (27; 28; 29), **characterized in that** at least some of the gaps (27; 28) are narrowed in the direction of the component contacting device (32).

2. The data carrier (10) according to claim 1, **characterized in that** the elastic, electroconductive material (50) is so configured that the spatial structure embossed by the spatially structured module contacting device (26) in the material (50) substantially remains also when the application of pressure decreases.

3. The data carrier (10) according to claim 1 or 2, **characterized in that** the gaps (27; 28; 29) are substantially distributed over the complete contact area of the module contacting device (26).

4. An electronic module (20), suitable for at least partial embedding in a data carrier body (12) of a portable data carrier (10), comprising a module contacting device (26) for electroconductively connecting the module (20) with an elastic, electroconductive material (50) of the data carrier (10), wherein the module contacting device (26) is so configured in spatially structured fashion that it is suitable, upon the embedding of the module (20) in the data carrier body (12), for embossing under the application of pressure a spatial structure in the elastic, electroconductive material (50), wherein the module contacting device (26) is configured to be flat and a contact area of the module contacting device (26) facing the elastic material (50) upon embedding is spatially structured by gaps (27; 28; 29), **characterized in that** at least some of the gaps (27; 28) are narrowed in the direction of the side of the contact area facing the elastic material (50) upon embedding.

5. The module (20) according to claim 4, **characterized in that** the gaps (27; 28; 29) are substantially distributed over the complete contact area of the module contacting device (26).

6. A method for manufacturing a portable data carrier (10) having a data carrier body (12) as well as an electronic module (20), comprising the steps of:
- arranging an elastic, electroconductive material (50) in a gap (42) of the data carrier body (12) in such a fashion that the material (50) is electroconductively connected with a component contacting device (32) of an electrical component (30) of the data carrier body (12);
- at least partially embedding the module (20) in the data carrier body (12) in such a fashion that the material (50) electroconductively connects under the application of pressure the component contacting device (32) and a module contacting device (26) of the module (20);
- wherein the module contacting device (26) is configured to be spatially structured,
**characterized in that**
upon embedding the module (20) the material (50) is so embossed in spatially structured fashion by the module contacting device (26) that the embossed spatial structure in the material (50) substantially remains also when the pressure application by the module contacting device (26) decreases,
wherein at least some of the gaps (27, 28) are narrowed in the direction of the component contacting device (32).

## Revendications

1. Support de données (10) portable comprenant un corps (12) de support de données ayant une composante électrique (30) ainsi qu'un module électronique (20) qui est au moins partiellement encastré dans le corps (12) de support de données et qui est, par l'intermédiaire d'un dispositif de contact de module (26) du module (20), au moyen d'un matériau (50) élastique électroconducteur, connecté, sous application d'une pression, de manière électroconductrice à un dispositif (32) de contact de composantes des composantes électriques (30) du support de données (10), le dispositif de contact de module (26) étant réalisé sous forme structurée spatialement et, dans le matériau (50) élastique électroconducteur, par le dispositif de contact de module (26) structuré spatialement, une structure spatiale étant gaufrée, le dispositif de contact de module (26) étant réalisé sous forme plane et une surface de contact tournée vers le dispositif (32) de contact de composantes du dispositif de contact de module (26) étant structuré spatialement par des évidements (27; 28; 29), **caractérisé en ce qu'**au moins certains des évidements (27; 28) s'effilent en direction du dispositif (32) de contact de composantes.

2. Support de données (10) selon la revendication 1, **caractérisé en ce que** le matériau (50) élastique électroconducteur est réalisé de telle façon que la structure spatiale gaufrée par le dispositif de contact de module (26) structuré spatialement demeure essentiellement dans le matériau (50) même en cas de baisse de l'application de pression.

3. Support de données (10) selon la revendication 1 ou 2, **caractérisé en ce que** les évidements (27; 28; 29) sont essentiellement répartis sur l'ensemble de la surface de contact du dispositif de contact de module (26).

4. Module électronique (20), adapté à l'encastrement au moins partiel dans un corps (12) de support de données d'un support de données (10) portable, comprenant un dispositif de contact de module (26) destiné à la connexion électroconductrice du module (20) avec un matériau (50) élastique électroconducteur du support de données (10), le dispositif de contact de module (26) étant réalisé de telle sorte sous forme structurée spatialement qu'il est adapté à, lors de l'encastrement du module (20) dans le corps (12) de support de données, gaufrer sous application d'une pression une structure spatiale dans le matériau (50) élastique électroconducteur, le dispositif de contact de module (26) étant réalisé sous forme plane et une surface de contact du dispositif de contact de module (26) tournée vers le matériau (50) élastique lors de l'encastrement étant structurée spatialement par des évidements (27; 28; 29), **caractérisé en ce qu'**au moins certains des évidements (27; 28) s'effilent en direction du côté de la surface de contact tourné vers le matériau (50) élastique lors de l'encastrement.

5. Module (20) selon la revendication 4, **caractérisé en ce que** les évidements (27; 28; 29) sont essentiellement répartis sur l'ensemble de la surface de contact du dispositif de contact de module (26).

6. Procédé de fabrication d'un support de données (10) portable ayant un corps (12) de support de données ainsi qu'un module électronique (20), comprenant les étapes:
• agencement d'un matériau (50) élastique électroconducteur dans un évidement (42) du corps (12) de support de données, de telle façon que le matériau (50) est connecté de manière électroconductrice à un dispositif (32) de contact de composantes d'une composante électrique (30) du corps de support de données (12);
• encastrement au moins partiel du module (20) dans le corps de support de données (12), de telle façon que le matériau (50) connecte de manière électroconductrice, sous application d'une pression, le dispositif (32) de contact de composantes à un dispositif de contact de module (26) du module (20);
• le dispositif de contact de module (26) étant réalisé sous forme structurée spatialement, **caractérisé en ce que**
• le matériau (50), lors de l'encastrement du module (20), est gaufré de manière structurée spatialement par le dispositif de contact de module (26) de telle façon que la structure spatiale gaufrée demeure essentiellement dans le matériau (50) même en cas de baisse de l'application de pression par le dispositif de contact de module (26),
• au moins certains des évidements (27; 28) s'effilant en direction du dispositif (32) de contact de composantes.
